# EUROPEAN PATENT APPLICATION

(11) **EP 4 191 681 A1**
(43) Date of publication of application: **07.06.2023**
(21) Application number: 22199938.6
(22) Date of filing: 06.10.2022
(51) Int. Cl.: H01L 29/06, H01L 29/10, H01L 29/66, H01L 29/737, H01L 29/732, H01L 21/8249, H01L 27/06

(54) **BIPOLAR TRANSISTORS OPTMISED FOR A BICMOS PROCESS USING DUMMY CMOS GATE STRUCTURES TO DEFINE THE BASE.**

(30) Priority: 06.12.2021 US 202117542793
(71) Applicant: GLOBALFOUNDRIES Singapore Pte. Ltd., Singapore 738406 (SG)
(72) Inventor: Cai, Xinshu, Singapore 738406 (SG); Tan, Shyue Seng, Singapore 738406 (SG); Jain, Vibhor, Essex Junction, VT 05452 (US); Pekarik, John J., Essex Junction, VT 05452 (US)
(74) Representative: Grünecker Patent- und Rechtsanwälte PartG mbB

(57) **Abstract**

The present disclosure relates to semiconductor structures and, more particularly, to bipolar transistors and methods of manufacture. The bipolar transistor includes: an extrinsic base region (28) above a plurality of gate structures (24a, 24b) on a semiconductor structure (12, 18, 20) and on a trench insulation; an intrinsic base region (28) between the plurality of gate structures on a collector (20), the collector being located underneath the gate structures and in a semiconductor substrate; an emitter (38) on the intrinsic base and laterally between the plurality of gate structures and separated from the extrinsic base by spacers (36).

## Description

### BACKGROUND

The present disclosure relates to semiconductor structures and, more particularly, to bipolar transistors and methods of manufacture.

Bipolar transistors can be vertical transistors or lateral transistors. In a vertical bipolar transistor, carriers flow in a vertical direction. Since a collector region is formed in a position deep from a wafer surface, collector resistance increases, thus limiting the transistor performance especially for high-speed operation. In addition, the transistor requires a high-concentration buried layer, a collector epitaxial layer, and a deep trench isolation, etc. Consequently, the number of process steps increases and thus does the costs. On the other hand, the lateral bipolar transistor is simpler in structure than the vertical bipolar transistor. Also, in a lateral bipolar transistor, a collector electrode can be directly brought into contact with a collector region, which is advantageous for high-speed operation.

### SUMMARY

In an aspect of the disclosure, a structure comprises: an extrinsic base region comprising at least a plurality of gate structures on a semiconductor material; an emitter between the plurality of gate structures; an intrinsic base region between the plurality of gate structures; and a collector region under the plurality of gate structures in the semiconductor material.

In an aspect of the disclosure, a structure comprises: an extrinsic base comprising a pair of gate structures and semiconductor material over the pair of gate structures; an emitter between the pair of gate structures and over the semiconductor material; and a collector comprising a doped semiconductor substrate under the extrinsic base.

In an aspect of the disclosure, a method comprises: forming an extrinsic base region comprising at least a plurality of gate structures on a semiconductor structure; forming an emitter between the plurality of gate structures; forming an intrinsic base region between the plurality of gate structures; and forming a collector region under the plurality of gate structures in the semiconductor material.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a substrate and isolation structures, amongst other features, and respective fabrication processes in accordance with aspects of the present disclosure.
FIG. 2 shows logic gate structures, amongst other features, and respective fabrication processes in accordance with aspects of the present disclosure.
FIG. 3 shows a base opening between the logic gate structures, amongst other features, and respective fabrication processes in accordance with aspects of the present disclosure.
FIG. 4 shows base material contacting the logic gate structures and within the base opening, amongst other features, and respective fabrication processes in accordance with aspects of the present disclosure.
FIG. 5 shows sidewall spacers on the base material, amongst other features, and respective fabrication processes in accordance with aspects of the present disclosure.
FIG. 6 shows an emitter between the sidewall spacers and contacts to the extrinsic base, the emitter and a collector, amongst other features, and respective fabrication processes in accordance with aspects of the present disclosure.
FIGS. 7-9 show alternative structures and respective fabrication processes.

### DETAILED DESCRIPTION

The present disclosure relates to semiconductor structures and, more particularly, to bipolar transistors and methods of manufacture. More specifically, the present disclosure relates to heterojunction bipolar transistors with logic gate structures within the extrinsic base region. In embodiments, the heterojunction bipolar transistors use logic gate material to form whole or part of an extrinsic base link. Advantageously, the heterojunction bipolar transistors provide reduced base resistance, lower capacitance between a collector and base region, e.g., Ccb, and higher Fmax. The bipolar transistors may also be used for applications in the millimeter waveband, e.g., 28 Gigahertz and higher; although other applications are also contemplated herein.

In embodiments, the bipolar transistors may be heterojunction bipolar transistors. The heterojunction bipolar transistors may be PNP devices or NPN devices. The bipolar transistors use logic gate structures in the base region. The logic gate structures include sidewall spacers which reduce base resistance. The logic gate structures also include either polysilicon material or metal gate material. In any configuration of the logic gate structures, though, the bipolar transistors exhibit lower Ccb and higher Fmax, compared to known bipolar transistors. Moreover, the logic gate structures may save an additional epitaxy process of the extrinsic base to lower the processing cost. In another embodiment, the gate structures can also be different from logic processes.

The bipolar transistors of the present disclosure can be manufactured in a number of ways using a number of different tools. In general, though, the methodologies and tools are used to form structures with dimensions in the micrometer and nanometer scale. The methodologies, i.e., technologies, employed to manufacture the bipolar transistor of the present disclosure have been adopted from integrated circuit (IC) technology. For example, the structures are built on wafers and are realized in films of material patterned by photolithographic processes on the top of a wafer. In particular, the fabrication of the bipolar transistors uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants as is known in the art.

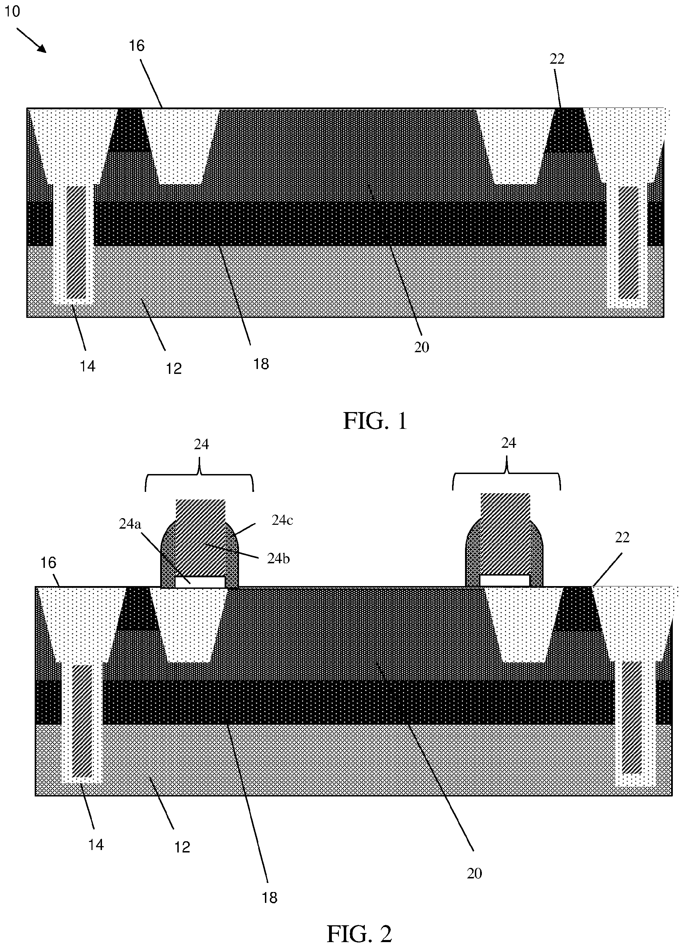

FIG. 1 shows substrate and isolation structures, amongst other features, and respective fabrication processes. In particular, the structure 10 of FIG. 1 includes a semiconductor substrate 12. The semiconductor substrate 12 may be composed of any suitable semiconductor material including, but not limited to, Si, SiC, GaAs, InAs, InP, and other III/V or II/VI compound semiconductors. In embodiments, the semiconductor substrate 12 may be a p-type substrate.

Still referring to FIG. 1, isolation trench structures 14, 16 are formed in the semiconductor substrate 12. For example, the isolation trench structures 14 may be deep trench isolation structures and the isolation trench structures16 may be shallow trench isolation structures. The isolation trench structures 14, 16 may be formed by conventional lithography and etching processes known to those of skill in the art. For example, to form the deep trench isolation structures 14 a resist formed over the semiconductor substrate 12 is exposed to energy (light) to form a pattern (opening). An etching process with a selective chemistry, e.g., reactive ion etching (RIE), will be used to form a pattern in the semiconductor substrate 12. Following the etching process, the resist may be removed by a conventional oxygen ashing process or other known stripants. An oxide material may be deposited on the sidewalls and bottom of the trenches, followed by a deposition of polysilicon material. For the shallow trench isolation structures 16, an oxide material may be deposited within the trenches.

FIG. 1 further shows wells 18, 20 and contact regions 22. The wells 18, 20 may be formed prior to or after the formation of the isolation trench structures 14, 16. In embodiments, the deep trench isolation structures extend blow the well 18. The wells 18, 20 may be N-type wells, with the well 18 more heavily doped (e.g., N+) than the well 20 (e.g., N-). The contact regions 22 may also be N-type doped regions provided between the shallow trench isolation regions 16. In embodiments, the N-type dopant may be arsenic or phosphorus, amongst other dopants. The well 20 may be used as a collector region of the transistor, with the contact regions 22 providing a contact to the collector region (e.g., well 20).

The regions 18, 20, 22 may be doped by an ion implantation process as is known in the art. For example, in embodiments, a patterned implantation mask may be used to define selected areas exposed for the implantations. The implantation mask may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions. The dopants can be driven into the semiconductor substrate 12 by a rapid thermal anneal process as is known in the art.

In FIG. 2, logic gate structures 24 are formed in the extrinsic base region of the transistor. In embodiments, the logic gate structures 24 may form part of the extrinsic base, and comprise a gate dielectric material 24a, a gate body material (e.g., electrode) 24b and sidewall spacers 24c. The logic gate structures 24 may be formed partially or completely over the shallow trench isolation structures 16. The logic gate structures 24 may also be formed over the collector region, e.g., N-well 20 in the semiconductor substrate 12. Illustratively and as a non-limiting example, the space between the gate structures 24 may be about 0.5 µm; although other dimensions are also contemplated herein depending on the designed performance parameters.

In embodiments, the gate dielectric material 24a may be either a low-k dielectric material, e.g., oxide material, or a high-k dielectric material, e.g., hafnium based material. The gate body material 24b may be a highly doped P+ polysilicon material and the sidewall spacers 24c may be an oxide material and a nitride material. Illustratively and as a non-limiting example, the thickness of the sidewall spacers 24 may be about 0.03 µm; although other dimensions are also contemplated herein depending on the designed performance parameters. And, by using a space of 0.54um between the shallow trench isolation structures 16 (e.g., extrinsic base) and a thickness of the sidewall spacers of 0.03um, it is possible to reduce Ccb and increase Fmax. The spacing between the gate and spacer structures form the intrinsic base region.

In embodiments, the gate structures 24 may be formed by conventional polysilicon gate processes. For example, the gate dielectric material 24a and the gate body material 24b may be deposited on the surface of the structure, followed by a conventional patterning process using lithography and etching processes as is known in the art. In embodiments, the gate dielectric material 24a may be deposited by atomic layer deposition, plasma enhanced chemical vapor deposition (PECVD) processes, etc. The gate body material 24b may be highly doped P+ polysilicon material deposited by a CVD process. The highly doped polysilicon may form part of the extrinsic base and connect to the intrinsic base.

Following the patterning process, an oxide material and a nitride material may be conformally deposited over the patterned materials 24a, 24b, followed by an anisotropic etching process to form the sidewall spacers 24c. In embodiments, the anisotropic etching process may be used to pull down or recess the sidewalls spacers 24c below the top surface of the gate body material 24b. In this way, a larger surface area of the gate body material 24b may be exposed for subsequent processing steps of the extrinsic base region. This larger surface area may effectively lower the base resistance Rb of the bipolar transistor.

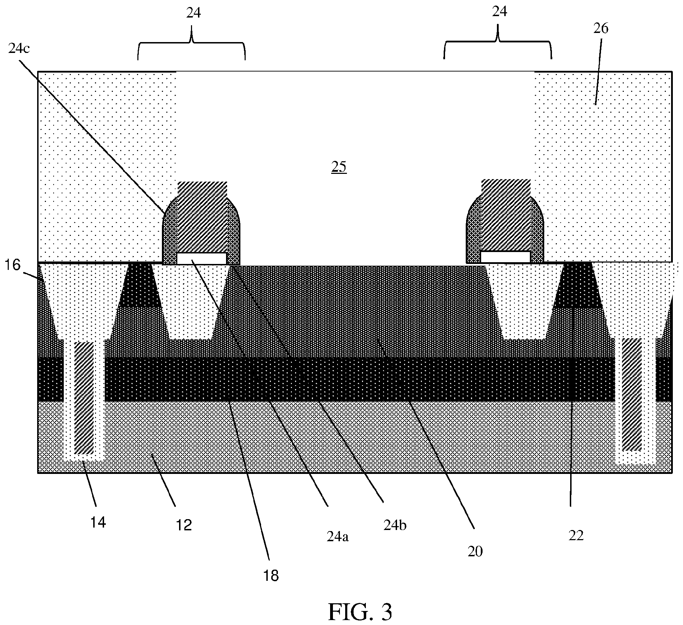

As shown in FIG. 3, an insulator material 26 may be formed over the gate structures 24. In embodiments, the insulator material 26 may be an oxide material and, more particularly, tetraethoxysilane (TEOS). As is known in the art, TEOS is self-planarizing, hence eliminating any need for a polishing process, e.g., chemical mechanical planarization (CMP). A base opening 25 may be formed in the insulator material 26, exposing the gate body material 24b of the gate structures 24 and the underlying semiconductor substrate 12. The base opening 25 may be formed by conventional lithography and etching processes as already described herein.

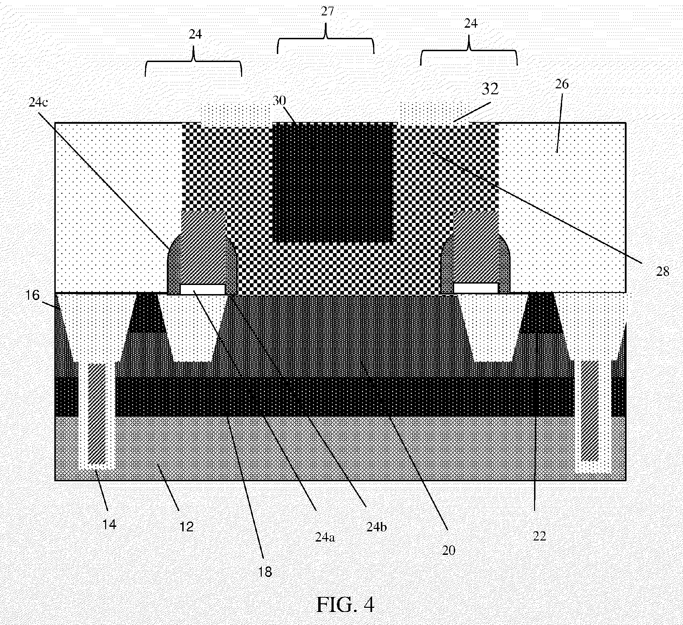

In FIG. 4, base materials 28 may be formed to partly fill the base opening 25, contacting the gate structures 24 and underlying semiconductor substrate 12 (e.g., collector region comprising the well 20). In embodiments, the base materials 28 may be U-shaped conforming to sidewalls and a bottom surface of the base opening 25. The base materials 28 may be comprised of a combination of materials, e.g., epitaxially grown Si/SiGe/Si. For example, the first layer of Si may be close to a collector region of the transistor, e.g., directly on the well 20 in the semiconductor substrate 12; whereas the second layer of Si may be closer to the emitter region 27 of the transistor. On the other hand, the SiGe material may be used as the intrinsic and extrinsic base region in electrical contact with the gate body material 24a of the gate structures 24.

In embodiments, the gate body material 24a may also form part of the extrinsic base and connect to the intrinsic base between the shallow trench isolation structures 16. Also, both layers of Si may be undoped, with the first layer of Si epitaxially grown directly on and electrically connected to the exposed semiconductor substrate 12 and gate body material 24b (e.g., polysilicon material). The SiGe material may also be epitaxially grown, with an in-situ doping process using P-type dopants, on the highly doped polysilicon gate body material 24b.

Following the deposition of the base materials 28, the remaining portion of the base opening 25 may be filled with a sacrificial material 30. For example, the sacrificial material 30 may be SiN, deposited using a conventional deposition process, e.g., CVD Any residual sacrificial material 30 on the insulator material 26 may be removed by a CMP process.

As further shown in FIG. 4, a mask layer 32 may be provided over the base materials 28, e.g., over the legs of the U-shaped base materials 28. In embodiments, the mask layer 32 may be an oxide material that is formed by an oxidation process as is known in the art. In this way, the semiconductor materials 28 may be covered or protected during subsequent fabrication processes as described herein.

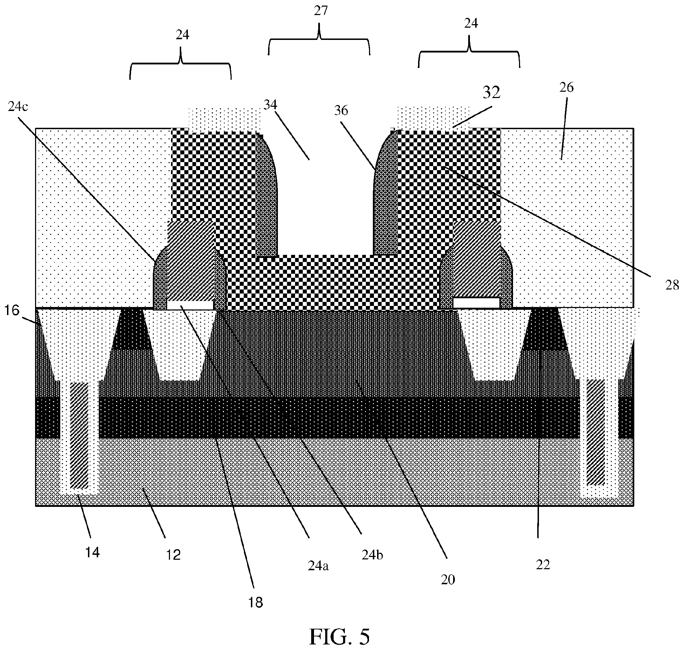

As shown in FIG. 5, the sacrificial material is removed to form an opening 34. The opening 34 will expose the sidewalls and bottom portion of the base materials 28. Sidewall spacers 36 are formed on the sidewalls of the exposed base materials 28, e.g., top layer of Si. In embodiments, the sidewall spacers 36 may be an oxide material and a nitride material formed by a conventional deposition process and anisotropic etching process. The anisotropic etching process will remove the sidewall spacer materials on horizontal surfaces, exposing the upper base material of the base materials 28.

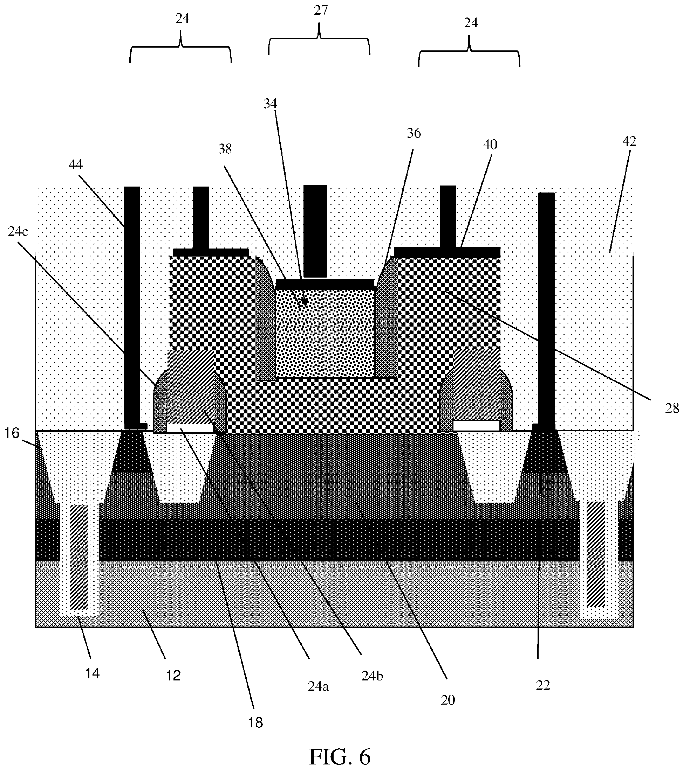

FIG. 6 shows an epitaxial semiconductor material 38 in the emitter region 27 on sides of the extrinsic base region, e.g., SiGe base material, and gate structures 24. More specifically, the epitaxial semiconductor material (e.g., emitter) 38 may be between the sidewall spacers 36 and directly contacting the top layer of the base materials 28. Also, the legs of the U-shaped base materials 28 may be on sides of the epitaxial semiconductor material (e.g., emitter) 38 with the base of the U-shaped base materials 28 laterally extending past the emitter material. Also, in this configuration, for example, the shallow trench isolation structures 18 will surround the emitter, e.g., epitaxial semiconductor material 38, and overlap with the base materials 28.

In embodiments, the epitaxial semiconductor material 38 may be a polysilicon material that is selectively grown only on the exposed portions of the base materials 28, from a bottom to a top of the opening 34. As should be understood by those of ordinary skill in the art, the epitaxial semiconductor material 38 may be used as the emitter of the transistor. Also, the mask layer 32 will prevent the epitaxial semiconductor material 38 from growing outside of the emitter region, e.g., outside of the opening 34 on the base materials 28.

FIG. 6 further shows contacts 44 formed to the extrinsic base region, e.g., SiGe material of the base materials 28 and gate structures24, the collector region, e.g., the contact regions 22 that electrically connect to the collector region (well 20 in the semiconductor substrate 12), and in the emitter region 27, e.g., the epitaxial semiconductor material 38. Prior to the deposition of the conductive material, a silicide 40 (e.g., NiSi) may be formed on the exposed semiconductor materials of the emitter, base and collector. As should be understood by those of skill in the art, the silicide process begins with deposition of a thin transition metal layer, e.g., nickel, cobalt or titanium, over the semiconductor materials. After deposition of the material, the structure is heated allowing the transition metal to react with exposed semiconductor material forming a low-resistance transition metal silicide, e.g., NiSi. Following the reaction, any remaining transition metal is removed by chemical etching, leaving silicide contacts 46.

The contacts 44, e.g., conductive material, may be deposited on the silicide contacts 40 within vias formed in interlevel dielectric material 42. The vias may be formed by conventional lithography and etching processes. A conductive material, e.g., tungsten or aluminum with a liner material, e.g., TiN, may be deposited within the vias to form the contacts 44. Any residual material on the interlevel dielectric material 50 may be removed by a CMP process.

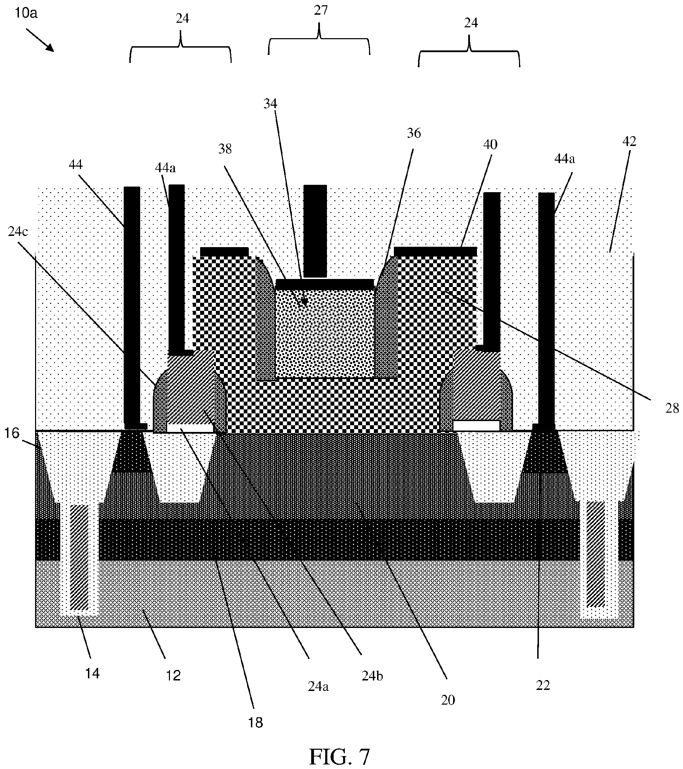

FIG. 7 shows an alternative structure 10a and respective fabrication processes. In the structure 10a, the base contact 44a lands on the logic gate polysilicon layer 24b; instead of the base layer 28, as shown in FIG. 6. The remaining structures are similar to that shown in FIGS. 1-6.

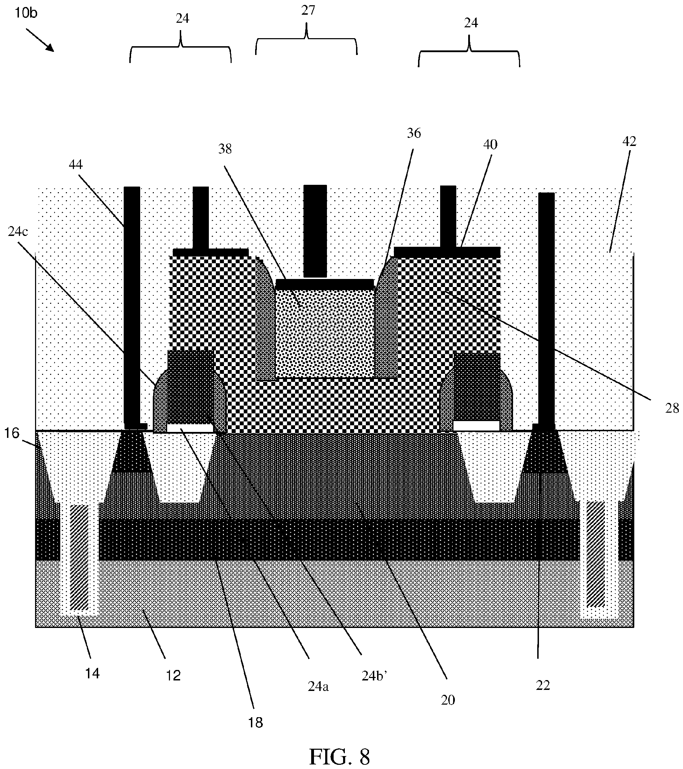

FIG. 8 shows an alternative structure 10b and respective fabrication processes. In the structure 10b, the gate body material 24b'may be a metal gate material, e.g., tungsten, cobalt, etc. In embodiments, the metal gate material 24b' will be used as part of the extrinsic base and connecting to the intrinsic base. Also, using the metal gate material 24b' it is now possible to minimize the base resistance. In embodiments, the metal gate material 24b' may be formed using known replacement gate or the gate first fabrication processes known to those of skill in the art such that no further explanation is needed for a complete understanding of the present disclosure. The remaining structures are similar to that shown in FIGS. 1-6.

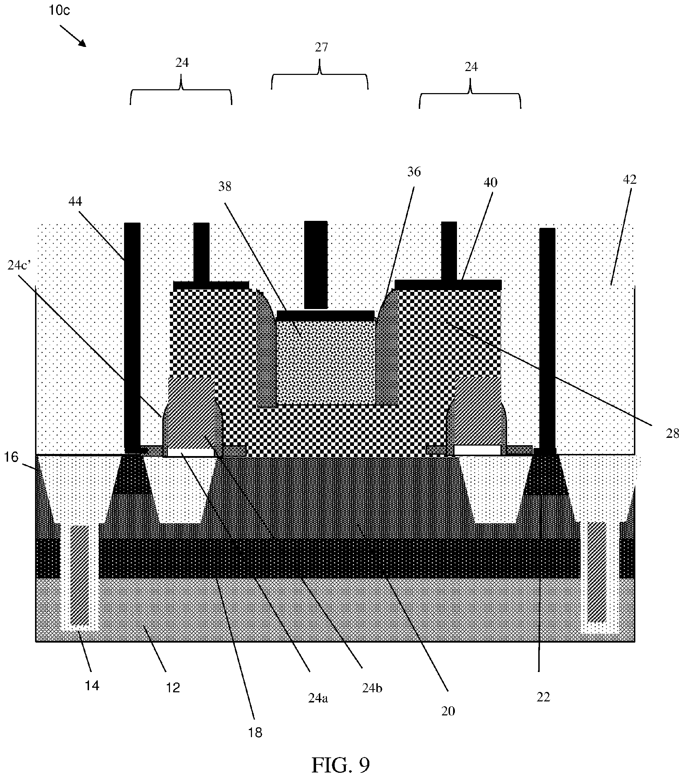

FIG. 9 shows an alternative structure 10c and respective fabrication processes. In the structure 10c, the sidewall spacers 24c' of the gate structure 24 are L-shaped sidewall spacers. The L-shaped sidewalls spacers 24c' may formed on either configuration of the gate structure 24, e.g., gate polysilicon material or gate metal material. In embodiments, the L-shaped spacers 24c' may be pulled down to below a surface of the gate body material 24 to increase the surface contact region of the gate body material 24 for the extrinsic and intrinsic base contact. This configuration will reduce the base resistance and Ccb. The remaining structures are similar to that shown in FIGS. 1-6.

The transistors can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

The following embodiments are explicitly disclosed:

### Embodiment 1:

A structure comprising:
an extrinsic base region comprising at least a plurality of gate structures on a semiconductor material;
an emitter between the plurality of gate structures;
an intrinsic base region between the plurality of gate structures; and
a collector region under the plurality of gate structures in the semiconductor material.

### Embodiment 2:

The structure of embodiment 1, wherein the plurality of gate structures comprises polysilicon material and the extrinsic base region further comprises SiGe material over the plurality of gate structures.

### Embodiment 3:

The structure of embodiment 1, wherein the plurality of gate structures comprises metal material and the extrinsic base region further comprises SiGe material over the plurality of gate structures.

### Embodiment 4:

The structure of one of embodiments 1 to 3, wherein the intrinsic base region comprises undoped Si material between the plurality of gate structures and under the extrinsic base region and/or SiGe material.

### Embodiment 5:

The structure of one of embodiments 1 to 4, further comprising insulator material on sidewalls of the extrinsic base material, wherein semiconductor material of the emitter contacts the insulator material and the extrinsic base material.

### Embodiment 6:

The structure of one of embodiments 1 to 5, further comprising oxidation of the extrinsic base material.

### Embodiment 7:

The structure of one of embodiments 1 to 6, wherein the plurality of gate structures comprises pulled down sidewall spacers to expose an electrode of the plurality of gate structures, the exposed electrode contacting semiconductor material of the extrinsic base region.

### Embodiment 8:

The structure of embodiment 7, wherein the pulled down sidewall spacers comprise L-shaped spacers.

### Embodiment 9:

The structure of one of embodiments 1 to 8, wherein the plurality of gate structures comprises two gate structures each of which are partially over a respective shallow trench isolation structure.

### Embodiment 10:

The structure of one of embodiments 1 to 8, wherein the plurality of gate structures comprises two gate structures each of which are fully over a respective shallow trench isolation structure.

### Embodiment 11:

The structure of one of embodiments 1 to 10, wherein the extrinsic base comprises a pair of gate structures and semiconductor material over the pair of gate structures, wherein the emitter is between the pair of gate structures and over the semiconductor material, and the collector region is a collector comprising a doped semiconductor substrate under the extrinsic base.

### Embodiment 12:

The structure of embodiment 11, wherein the pair of gate structures comprise a polysilicon material with sidewalls spacers extended toward an intrinsic base.

### Embodiment 13:

A structure comprising:
an extrinsic base comprising a pair of gate structures and semiconductor material over the pair of gate structures;
an emitter between the pair of gate structures and over the semiconductor material; and
a collector comprising a doped semiconductor substrate under the extrinsic base.

### Embodiment 14:

The structure of one of embodiments 11 to 13, wherein the pair of gate structures comprise a polysilicon material with sidewalls spacers extended toward an intrinsic base.

### Embodiment 15:

The structure of one of embodiments 11 to 14, wherein the pair of gate structures comprise a metal gate material with sidewalls spacers extended toward an intrinsic base.

### Embodiment 16:

The structure of one of embodiments 11 to 15, wherein the pair of gate structures are partially on shallow trench isolation structures.

### Embodiment 17:

The structure of one of embodiments 11 to 16, wherein the pair of gate structures are fully on the shallow trench isolation structures.

### Embodiment 18:

The structure of one of embodiments 11 to 17, further comprising sidewall spacers on semiconductor material of the extrinsic base, wherein the emitter is between the sidewall spacers.

### Embodiment 19:

The structure of one of embodiments 11 to 18, further comprising an intrinsic base region between the pair of gate structures.

### Embodiment 20:

The structure of one of embodiments 11 to 19, wherein the semiconductor material over the pair of gate structures comprises a U-shape, with the emitter between legs of the U-shape.

### Embodiment 21:

The structure of one of embodiments 11 to 20, wherein the semiconductor material comprises Si/SiGe/Si, with the Si underneath the SiGe being part of an intrinsic base.

### Embodiment 22:

A method comprising:
forming an extrinsic base region comprising at least a plurality of gate structures on a semiconductor structure;
forming an emitter between the plurality of gate structures;
forming an intrinsic base region between the plurality of gate structures; and
forming a collector region under the plurality of gate structures in the semiconductor
material. The method may form the structure of one of embodiments 1 to 21.

## Claims

1. A structure comprising:
an extrinsic base region comprising at least a plurality of gate structures on a semiconductor material;
an emitter between the plurality of gate structures;
an intrinsic base region between the plurality of gate structures; and
a collector region under the plurality of gate structures in the semiconductor material.

2. The structure of claim 1, wherein the plurality of gate structures comprises polysilicon material or metal material and the extrinsic base region further comprises SiGe material over the plurality of gate structures, and/or wherein the intrinsic base region comprises undoped Si material between the plurality of gate structures and under SiGe material.

3. The structure of claim 1 or 2, further comprising insulator material on sidewalls of the extrinsic base material, wherein semiconductor material of the emitter contacts the insulator material and the extrinsic base material, and/or oxidation of the extrinsic base material.

4. The structure of one of claims 1 to 3, wherein the plurality of gate structures comprises pulled down sidewall spacers to expose an electrode of the plurality of gate structures, the exposed electrode contacting semiconductor material of the extrinsic base region, the pulled down sidewall spacers preferably comprising L-shaped spacers.

5. The structure of one of claims 1 to 4, wherein the plurality of gate structures comprises two gate structures each of which are at least partially over a respective shallow trench isolation structure.

6. The structure of one of claims 1 to 5, wherein the extrinsic base comprises a pair of gate structures and semiconductor material over the pair of gate structures, wherein the emitter is between the pair of gate structures and over the semiconductor material, and the collector region is a collector comprising a doped semiconductor substrate under the extrinsic base.

7. The structure of claim 6, wherein the pair of gate structures comprise a polysilicon material with sidewalls spacers extended toward an intrinsic base.

8. The structure of claim 6 or 7, wherein the pair of gate structures comprise a metal gate material with sidewalls spacers extended toward an intrinsic base.

9. The structure of one of claims 6 to 8, wherein the pair of gate structures are at least partially on shallow trench isolation structures.

10. The structure of one of claims 6 to 9, further comprising sidewall spacers on semiconductor material of the extrinsic base, wherein the emitter is between the sidewall spacers.

11. The structure of one of claims 6 to 10, further comprising an intrinsic base region between the pair of gate structures.

12. The structure of one of claims 6 to 11, wherein the semiconductor material over the pair of gate structures comprises a U-shape, with the emitter between legs of the U-shape.

13. The structure of one of claims 6 to 12, wherein the semiconductor material comprises Si/SiGe/Si, with the Si underneath the SiGe being part of an intrinsic base.

14. A method comprising:
forming an extrinsic base region comprising at least a plurality of gate structures on a semiconductor structure;
forming an emitter between the plurality of gate structures;
forming an intrinsic base region between the plurality of gate structures; and
forming a collector region under the plurality of gate structures in the semiconductor material.

15. The method of claim 14, wherein the structure of one of claims 1 to 13 is formed.
